**Europäisches Patentamt**

**European Patent Office**

**Office européen des brevets**

(19)

(11) Numéro de publication : **0 500 882 B1**

(12)

# FASCICULE DE BREVET EUROPEEN

(45) Date de publication du fascicule du brevet :
**29.11.95 Bulletin 95/48**

(51) Int. Cl.⁶ : **H01S 3/06, H01S 3/094**

(21) Numéro de dépôt : **91916175.2**

(22) Date de dépôt : **10.09.91**

(86) Numéro de dépôt international :
**PCT/FR91/00715**

(87) Numéro de publication internationale :
**WO 92/04748 19.03.92 Gazette 92/07**

(54) **LASER A GUIDES OPTIQUES COUPLES.**

(30) Priorité : **11.09.90 FR 9011204**

(43) Date de publication de la demande :
**02.09.92 Bulletin 92/36**

(45) Mention de la délivrance du brevet :
**29.11.95 Bulletin 95/48**

(84) Etats contractants désignés :
**DE GB IT**

(56) Documents cités :
**GB-A- 2 095 419**
**US-A- 3 725 809**
**US-A- 4 763 975**
**SPIE, volume 1131, Optical Space Communication, Paris, 24-26 April 1989, E.LALLIER et
al.: "Towards a laser diode pumped
Nd:LiNbO3 waveguide laser", pages 247-251**

(73) Titulaire : **THOMSON-CSF**
**173, Boulevard Haussmann**
**F-75008 Paris (FR)**

(72) Inventeur : **POCHOLLE, Jean-Paul**
**1, allée Victor-Hugo**
**F-91290 Arpajon-la-Norville (FR)**
Inventeur : **LALLIER, Eric**
**107, rue du Président-Wilson**
**F-92300 Levallois (FR)**
Inventeur : **PAUPCHON, Michel**
**16, rue du Bas-de-la-Ferme**
**F-91140 Villebon (FR)**

(74) Mandataire : **Guérin, Michel et al**
**THOMSON-CSF**
**SCPI**
**B.P. 329**
**50, rue Jean-Pierre Timbaud**
**F-92402 Courbevoie Cédex (FR)**

EP 0 500 882 B1

## Description

L'invention concerne les sources optiques cohérentes, et notamment les lasers à l'état solide.

On a déjà imaginé des lasers fonctionnant sur le principe d'une structure à guides optiques multiples parallèles couplés entre eux latéralement (structure multiguide optique).

Dans ces structures, si l'on place des guides optiques côte à côte, très proches les uns des autres, il y a couplage mutuel de l'onde optique circulant dans un guide avec l'onde optique des guides voisins. On peut donc, en jouant sur les couplages mutuels entre guides, c'est-à-dire en pratique en choisissant correctement les distances entre guides voisins, obtenir en sortie, des ondes optiques cohérentes avec une distribution de champ électrique, donc d'énergie lumineuse, qui n'est pas la simple superposition des champs électriques produits dans chaque guide mais qui est une composition correspondant à un mode de propagation propre à la structure multiguides.

Par conséquent, alors que des guides juxtaposés non couplés aboutiraient à une distribution d'énergie lumineuse répartie régulièrement entre les sorties des différents guides, le couplage optique mutuel peut aboutir à une distribution d'énergie non uniforme, éventuellement concentrée au centre par exemple avec la forme approximative d'une gaussienne. Une telle structure est donc très intéressante puisqu'elle permet de concentrer l'énergie à partir d'une sortie distribuée dans l'espace.

Malheureusement, l'expérience montre que la réalisation pratique est très difficile. En effet, il est très difficile de maîtriser les dimensions et l'homogénéité des guides optiques, et on n'a pas véritablement réussi à faire fonctionner un laser de cette manière, avec un faisceau présentant réellement un mode propre global à partir des modes individuels des différents guides. On n'obtient donc pas une concentration d'énergie correcte.

On a essayé de le faire par exemple avec des lasers à semiconducteurs, dans lesquels l'émission de lumière est stimulée par l'injection de courants dans des jonctions. Mais on s'aperçoit que l'injection de courant modifie les indices de réfraction dans les guides. Ces modifications d'indice modifient les phases des ondes optiques. On n'arrive pas à obtenir dans les différents guides une répartition de phases qui se combineraient pour donner une intensité de faisceau distribuée spatialement de la manière désirée.

L'invention propose un moyen de réaliser un laser fonctionnant sur le principe des structures multiguides optiques et ayant une distribution d'intensité de sortie souhaitée.

Selon l'invention, on propose un laser tel que défini dans la revendication 1.

Ce laser comporte en résumé une pluralité de guides optiques parallèles juxtaposés présentant entre eux un couplage optique latéral mutuel, avec des moyens pour contrôler individuellement l'indice de réfraction dans les différents guides ou entre les différents guides. Par cette commande individuelle locale des indices on peut contrôler les phases relatives de l'onde optique dans les différents guides et donc la distribution d'intensité lumineuse globale en sortie de la structure couplée.

La réalisation préférée est la suivante : les guides optiques sont réalisés en un matériau électrooptique et il est prévu des électrodes de commande placées au voisinage des guides pour commander individuellement l'indice de réfraction dans les guides, et des moyens pour appliquer à ces électrodes des potentiels individuels de manière à ajuster les phases relatives des ondes dans les différents guides. Cet ajustement de phase est fait par l'intermédiaire d'un ajustement de l'indice de réfraction effectif dans un guide ; l'indice du guide dépend du potentiel appliqué sur une électrode placée au voisinage de ce guide du fait que le guide est réalisé en matériau électrooptique.

Dans cette réalisation, les guides optiques font partie intégrante de la cavité résonnante produisant l'effet laser. Des miroirs plans ou d'autres moyens de réflexion sont placés aux extrémités des guides pour constituer cette cavité.

On peut ainsi réaliser un laser solide dans un substrat sur lequel on forme des guides optiques dans un matériau susceptible d'émettre de la lumière stimulée, pourvu que ce matériau présente des propriétés électrooptiques, c'est-à-dire en pratique un indice de réfraction effectif commandable.

Le niobate de lithium dopé au néodyme (Nd: LiNbO$_3$) par exemple est un matériau solide stimulable et de plus il est électrooptique c'est-à-dire que son indice de réfraction est commandable électriquement.

Plus généralement d'autres matériaux à propriétés électrooptiques sont utilisables s'ils permettent de réaliser des guides optiques et s'ils peuvent être dopés pour permettre l'émission laser. Cela suppose en général que le matériau soit cristallin et transparent à la longueur d'onde de la transition laser et également transparent, lorsque l'émission est stimulée par un laser de pompage, à la longueur d'onde du laser de pompage. Le tantalate de lithium est un exemple d'un tel matériau.

Dans une réalisation particulière, on dispose des miroirs plans aux extrémités des guides pour constituer une cavité laser. Dans une autre réalisation, les miroirs sont remplacés par des réseaux de Bragg distribués, aux extrémités des guides, ces réseaux ayant la propriété connue de réfléchir les ondes électromagnétiques à une longueur d'onde particulière (égale à deux fois le pas du réseau divisé par l'indice de réfraction effectif dans les guides).

Pour l'excitation du laser on peut utiliser des diodes laser de pompe, soit individuelles soit couplées (diode laser multiruban). Si on utilise des diodes individuelles séparées, elles seront de préférence reliées aux entrées de la structure laser multiguide de l'invention par l'intermédiaire d'une optique de transfert à guides optiques.

Dans une variante de réalisation, les guides de la structure laser multiguides ne s'étendent pas tous entre les miroirs définissant la cavité laser. Mais ils sont quand même tous couplés entre eux.

D'autres caractéristiques et avantages de l'invention apparaîtront à la lecture de la description détaillée qui suit et qui est faite en référence aux dessins annexés dans lesquels :

- la figure 1 représente une structure multiguide optique,
- la figure 2 représente des configurations de champ électrique en sortie de la structure de la figure 1 pour des guides non couplés (2a) et couplés (2b),
- la figure 3 représente une structure laser multiguides selon l'invention;
- la figure 4 représente des répartitions possibles (4a et 4b) de champ électrique en sortie de la structure de la figure 3;
- la figure 5 représente une réalisation avec miroirs de Bragg en réseaux distribués;
- la figure 6 représente une réalisation avec excitation par diode laser multiruban;
- la figure 7 représente une réalisation avec excitation par des diodes laser individuelles, avec une optique de transfert en optique guidée;
- la figure 8 représente une réalisation avec excitation par une diode unique, avec une optique guidée à guides couplés entre cette diode et la structure laser multiguides de l'invention.
- la figure 9 représente une réalisation de la structure laser multiguides avec des guides ne s'étendant pas entre les deux miroirs formant la cavité laser.
- la figure 10 représente un autre mode de réalisation de l'invention.

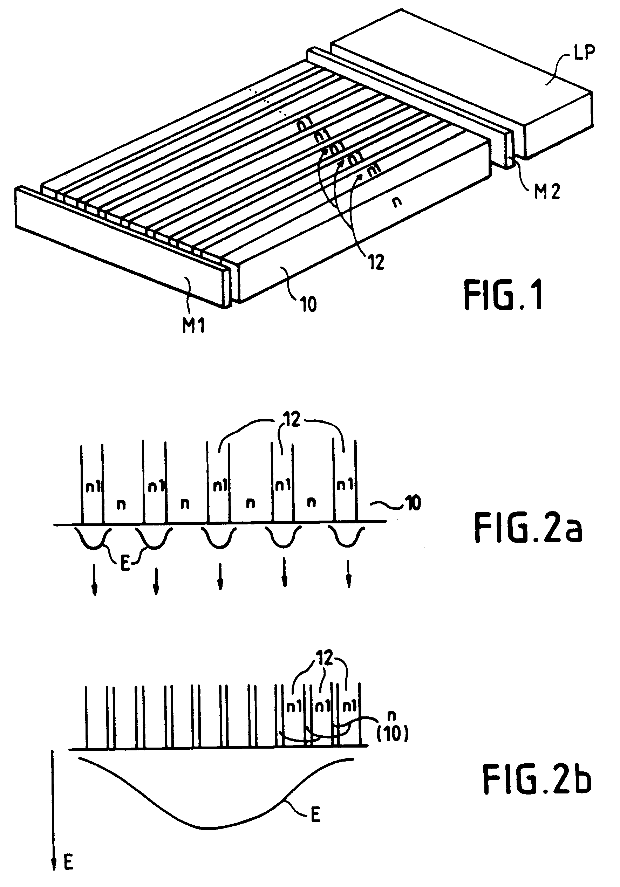

A la figure 1, on a représenté un substrat cristallin 10, par exemple en niobate de lithium, dans lequel on a formé des guides optiques juxtaposés 12. Ces guides sont réalisés par exemple par dopage de bandes longitudinales de faible largeur (de l'ordre de la longueur d'onde d'émission du laser à réaliser, par exemple de quelques microns pour une longueur d'onde d'environ 1 micron). Ces bandes longitudinales présentent après dopage (par exemple dopage au titane ou échange protonique) un indice de réfraction n1 supérieur à l'indice n du cristal dans lequel les bandes sont formées. Elles forment donc des guides optiques. Leur nombre peut être de quelques unités à quelques dizaines ou même plus.

Des miroirs M1, M2 sont placés aux extrémités du cristal, séparés par un multiple de la longueur d'onde du laser, ces miroirs étant réfléchissants pour cette longueur d'onde pour créer une cavité laser d'une longueur de quelques millimètres à quelques centimètres par exemple.

Les guides optiques sont dopés au néodyme par exemple pour pouvoir émettre, et l'émission est stimulée par un laser de pompage LP placé derrière l'un des miroirs (M2). Ce miroir M2 doit être transparent à la longueur d'onde du laser de pompage alors qu'il est réfléchissant pour la lumière du laser au néodyme. Une telle structure correspond en réalité à une multiplicité de lasers individuels constitués chacun par l'un des guides, les portions de miroirs qui l'enferment, et un laser de pompage ou un élément de laser de pompage émettant en face de ce guide.

La distribution de champ électrique en sortie de cette structure est celle de la figure 2a dans le cas où les guides ne sont pas couplés optiquement par les ondes évanescentes (par exemple parce que ces guides sont trop éloignés les uns des autres) ; chaque guide propage une onde avec un mode propre correspondant à ce guide. La distribution de champ E et par conséquent d'intensité lumineuse en sortie est régulièrement répartie entre les différents guides. Il s'agit en quelque sorte d'une pluralité de faisceaux lasers juxtaposés mais pas d'un faisceau laser unique.

Si maintenant on rapproche les bandes longitudinales à une distance de l'ordre de la longueur d'onde ou quelques longueurs d'onde, il y a couplage optique entre les guides, c'est-à-dire que les équations de Maxwell régissant les champs électriques ne sont plus définies par les mêmes conditions aux limites.

Il y a interaction entre les faisceaux, le champ électromagnétique se propage avec un mode propre et le champ électrique E présente une distribution qui est très différente de la distribution de la figure 2a. Dans une configuration théorique tout à fait envisageable, les interactions entre les ondes optiques aboutissent à la configuration de champ de la figure 2b : la concentration d'énergie est maximale au centre. La structure propage l'énergie selon un mode propre et pas selon la simple juxtaposition des modes des guides individuels comme à la figure 2a. Tout se passe comme si on avait un laser unique avec une distribution d'énergie répartie sur une zone large, avec une concentration plus importante au centre.

Cependant, cette configuration optimale n'existe véritablement qu'à condition que les ondes optiques se propageant dans chacun des guides se composent correctement, et le facteur clé qui détermine la composition des champs électriques dus à deux ondes couplées est la phase relative de ces deux ondes.

Si la structure à guides couplés était parfaite, on pourrait, en choisissant convenablement les dimensions et espacements des guides, en fonction des indices de réfraction des guides et des intervalles qui les séparent, obtenir facilement un champ électrique composé ayant la distribution de la figure 2b.

Mais les limitations technologiques ne permettent pas de le faire : il y a des imprécisions de réalisation des dimensions voulues et il y a des inhomogénéités de matériaux, de dopage, etc. qui entraînent des modifications de phase relatives imprévisibles dans les ondes propagées.

C'est pourquoi l'invention propose de commander localement et individuellement la valeur de l'indice de réfraction des différents guides (ou au moins certains d'entre eux), en sachant qu'une variation d'indice entraîne une modification de phase de l'onde propagée.

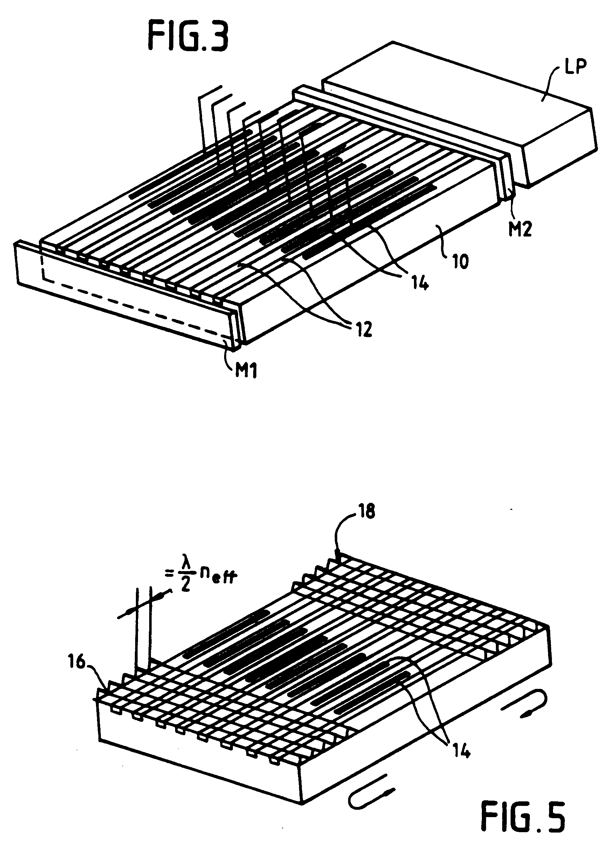

Sur la figure 3, on a représenté l'exemple de réalisation préférentiel consistant à placer sur chaque guide ou au voisinage immédiat de ce guide une électrode de commande ayant un effet électrooptique, c'est-à-dire créant dans le guide (et seulement dans ce guide) une variation de l'indice de réfraction effectif du milieu de propagation.

En appliquant à chaque électrode un potentiel approprié on peut régler la phase de l'onde propagée dans le guide correspondant, relativement aux phases dans les autres guides.

On peut ainsi rectifier toutes les erreurs de phase qui seraient dues à des inhomogénéités des guides optiques ou à des erreurs de précision dans les dimensions.

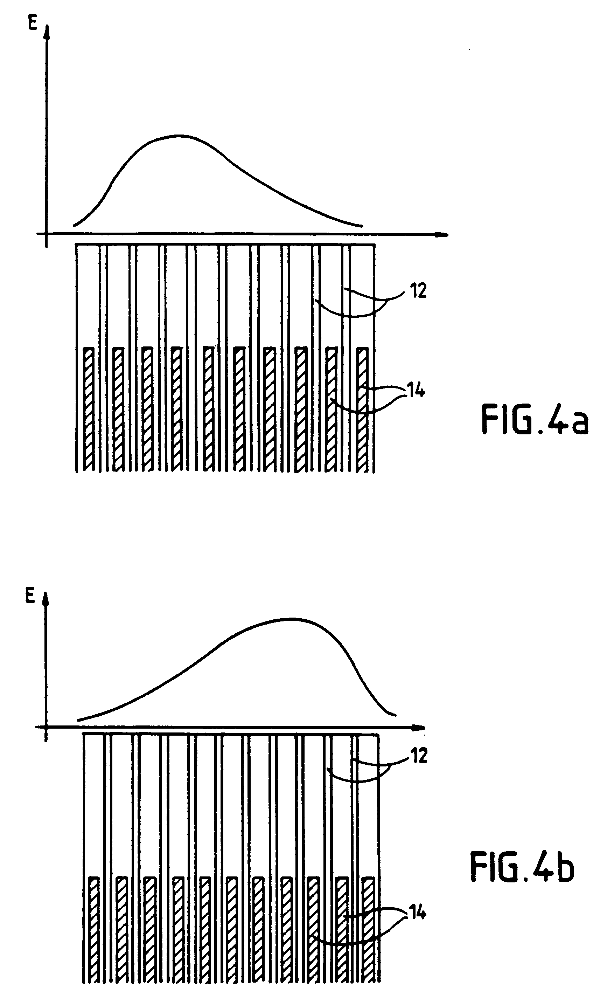

Mais on peut aussi utiliser ces électrodes pour configurer le champ électrique en sortie de la structure d'une manière différente de la configuration la plus simple de la figure 2b. En effet, les potentiels des électrodes peuvent servir à donner par exemple des configurations de champ électrique dissymétriques telles que celles de la figure 4a ou la figure 4b.

En effet, comme on l'a expliqué, la composition des champs électriques dans les guides couplés est directement liée aux phases des ondes dans les guides individuels et les phases sont directement affectées par les potentiels appliqués sur les électrodes du fait des propriétés électrooptiques du matériau constituant les guides.

On obtient ainsi une application très importante de l'invention qui est l'obtention d'une directivité variable du faisceau laser, avec une commande électrique de cette directivité; cette directivité est obtenue à l'intérieur même du laser et pas par un composant optique placé en aval du laser.

Dans le cas de la figure 4a, la configuration de champs électriques correspond directement à un faisceau laser d'énergie répartie selon un lobe dont l'orientation générale est d'axe décalé à gauche par rapport à l'axe des guides optiques parallèles. Dans le cas de la figure 4b, le faisceau est directif et orienté vers la droite.

Avec une configuration de potentiels variable on peut, si on le désire, effectuer l'équivalent d'un balayage du faisceau laser, la direction d'intensité maximale du faisceau variant avec les potentiels appliqués; ce balayage est similaire au balayage électronique dans les antennes radars, dans lesquels un balayage de directivité d'émission est obtenu par déphasage approprié des fréquences émises par des antennes élémentaires proches les unes des autres.

La configuration non symétrique du champ électrique à proximité immédiate de la sortie des guides de la structure correspond en effet à un diagramme de rayonnement directif en champ lointain avec un lobe décalé par rapport à l'axe.

Les électrodes 14 destinées à modifier les phases de propagation respectives individuelles dans les différents guides 12 peuvent être disposées soit juste au dessus des guides soit entre les guides.

Pour réaliser la cavité laser dans la structure à guides optiques multiples selon l'invention, il y a plusieurs solutions. L'une des solutions est l'utilisation de miroirs déposés aux extrémités des guides, séparés par un multiple de la longueur d'onde de l'émission laser (environ 1,084 micromètre pour un laser au néodyme). Les miroirs peuvent être rapportés ou être déposés directement sur les extrémités de la structure.

Le miroir M2 est caractérisé par un coefficient de transmission élevé à la longueur d'onde du laser de pompe LP, alors qu'il présente un coefficient de réflexion maximum à la longueur d'onde de l'émission laser. Le miroir M1 a un coefficient de réflexion ajusté en fonction de la grandeur du coefficient de surtension désiré pour la cavité, en tenant compte du gain et des pertes de celle-ci.

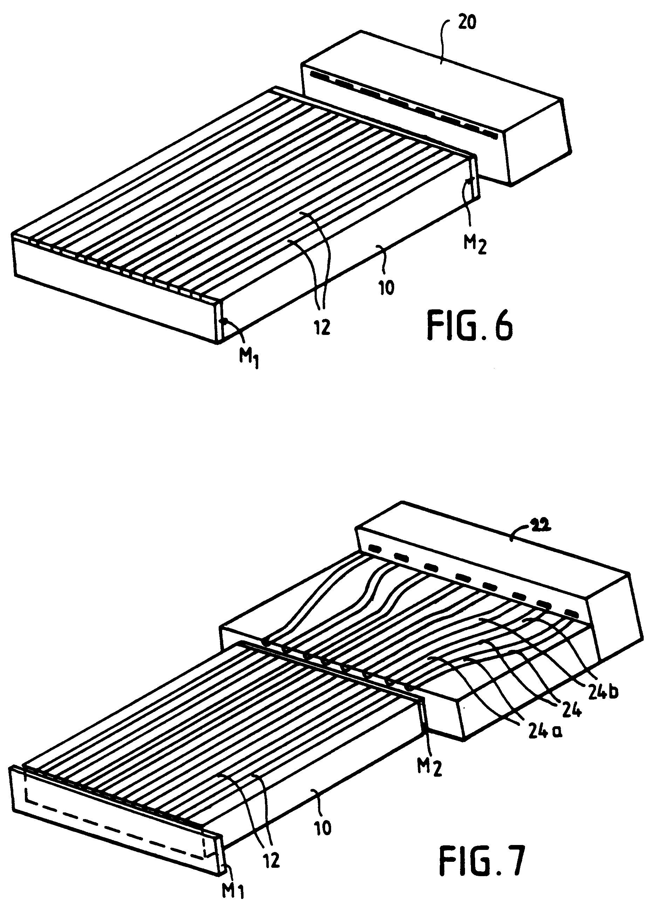

Une autre manière de réaliser la cavité laser est de remplacer les miroirs par des réseaux distribués déposés sur la structure et ayant la même fonction que les miroirs, c'est-à-dire capables de renvoyer en arrière une onde électromagnétique de longueur d'onde donnée. La figure 5 schématise l'utilisation de tels réseaux 16 et 18, à chaque extrémité de la structure; le pas p du réseau est choisi égal au produit de la longueur d'onde lambda de la lumière à réfléchir par la moitié de l'indice de réfraction effectif $n_{eff}$ dans la structure pour le mode propre de celle-ci à la longueur d'onde considérée. Les électrodes 14 permettant de modifier le mode propre de propagation sont placées le long des guides entre les réseaux 16 et 18.

Le pompage de la structure est réalisé de préférence à partir d'une diode laser ou d'un ensemble de diodes laser. la longueur d'onde d'émission des diodes de pompage est en résonnance avec la bande d'absorption de l'ion de terre rare utilisé (par exemple 0,814 micromètre pour le néodyme sous la forme $Nd^{3+}$ inséré dans du niobate de lithium). Pour obtenir cette longueur d'onde précise dans les diodes laser de pompe, on contrôle les compositions et épaisseurs des couches semiconductrices à base d'arséniure de gallium-aluminium composant les diodes. On peut utiliser aussi des diodes laser à puits quantiques multiples.

Le couplage de l'onde de pompe à la structure laser à multiguides peut se faire de différentes manières. La première consiste à utiliser une diode laser multirubans dont la dimension du mode propre s'adapte le mieux à celle du mode propre de la structure multiguide à la longueur d'onde de pompe. On peut employer une optique de couplage à la longueur d'onde de pompe adaptant ces deux modes. Une telle structure à diode multirubans 20 est représentée sur la figure 6. Les électrodes de la structure multiguides ne sont pas représentées sur cette figure par souci de simplification.

Une seconde méthode repose sur l'emploi d'une optique de transfert (figure 7) reliant des diodes laser 22 de pompe (séparées latéralement donc non couplées mutuellement) ou d'une diode laser multiruban à l'entrée de la structure laser multiguides de l'invention. Cette optique de transfert comporte des guides optiques 24 qui, dans leur partie amont 24b (du côté des diodes lasers 22, ou de la diode laser multirubans) sont en regard des diodes laser 22 de pompe et qui se rapprochent (Fig. 7) ou s'éloignent jusqu'à être en regard des guides optiques 12 portés par le substrat 10 dans leur partie ovale 24a (du côté de la structure multiguide selon l'invention). La lumière laser de pompe issue des diodes 22 et passant par les guides 24 traverse le miroir M2 et vient exciter la terre rare de dopage des guides 12 de la structure laser selon l'invention. Cette solution convient lorsque l'onde de pompe est constituée à partir d'un ensemble de sources lumineuses indépendantes les unes des autres ou d'une diode multirubans dont le mode propre est différent de celui de la structure laser multiguides à la longueur d'onde de pompe. Le mode propre en sortie de l'optique de transfert à guides 24 est de préférence choisi identique au mode propre du guide laser 10, 12 à la longueur d'onde de pompe. Sur la figure 7, les électrodes 14 ne sont pas représentées.

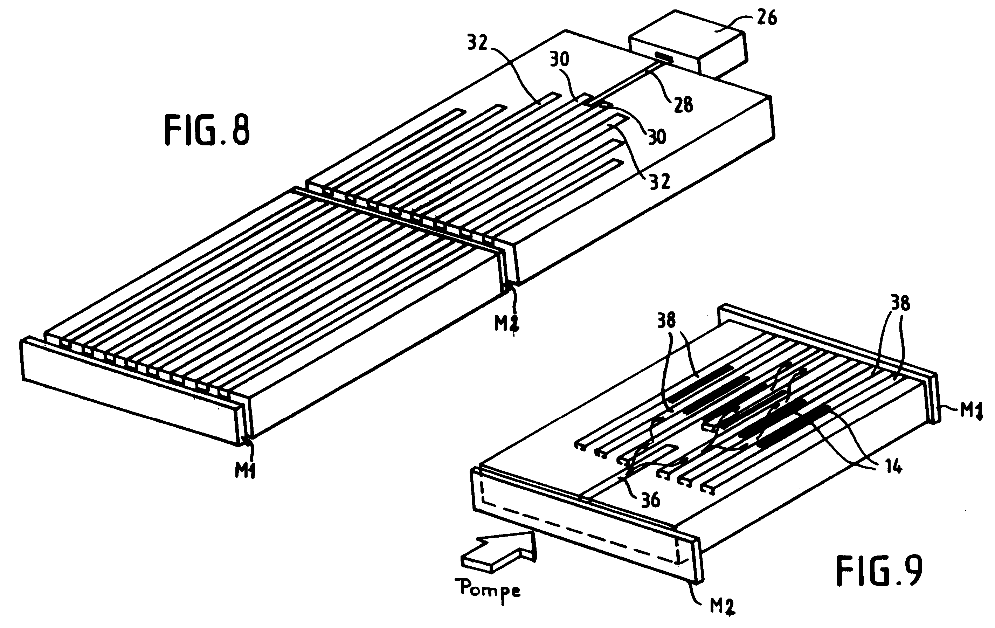

Une troisième solution (figure 8) consiste à utiliser une optique de transfert intégrée à guides couplés entre une diode laser individuelle 26 et la structure multiguides de l'invention. La diode laser unique émet un rayonnement laser de pompe vers une extrémité d'un premier guide 28 dont une autre extrémité est couplée latéralement à d'autres guides 30, qui eux-mêmes sont couplés latéralement à d'autres guides 32, etc. Par couplage mutuel, l'énergie injectée se distribue entre ces différents guides qui forment ensemble l'équivalent d'une lentille optique intégrée; les sorties de ces guides 30, 32, etc. sont disposées en face des entrées des guides de la structure laser multiguide de l'invention. Là encore, les électrodes 14 de commande des phases servant à établir le mode de propagation désiré ne sont pas représentées.

Dans une autre réalisation encore, représentée à la figure 9, la structure laser multiguide couplée à supermode de propagation comprend des guides dont les longueurs sont inférieures à la distance séparant les miroirs M1 et M2 qui définissent la cavité laser. Certains guides arrivent à proximité immédiate du miroir M2 pour recevoir l'onde laser de pompe (par exemple le guide 36 de la figure 9) mais ne s'étendent pas jusqu'à l'autre miroir. D'autres guides tels que 38 s'étendent jusqu'à proximité du miroir M1 du côté de la sortie de la structure, mais ne s'étendent pas jusqu'au miroir d'entrée M2. Les guides 36 et les guides 38 sont couplés entre eux et les successions de guides couplés s'étendant entre les deux miroirs forment des cavités dans lesquelles peut se produire la résonance laser. Les électrodes servent là encore à modifier les phases pour ajuster le supermode de propagation laser de la structure.

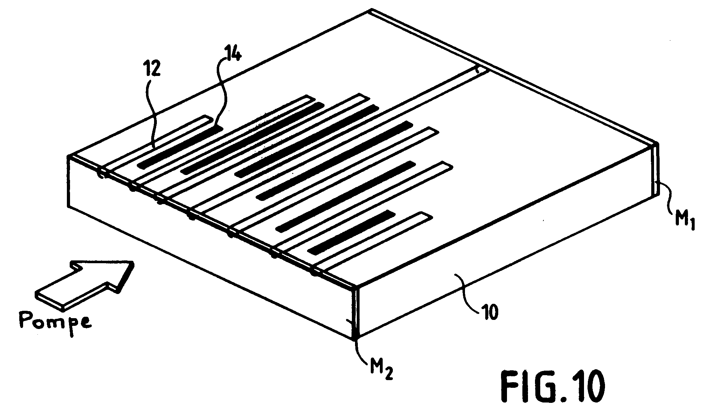

Dans une autre réalisation encore, représentée à la figure 10, la structure laser multiguides couplée comprend des guides dont les longueurs sont inférieures à la distance séparant les miroirs M1 et M2 qui définissent la cavité laser.

Dans cette réalisation, tous les guides arrivent à proximité immédiate du miroir M2 pour recevoir l'onde laser de pompe, mais ne s'étendent pas jusqu'à l'autre miroir sauf pour un des guides (le guide central de préférence). La longueur de chaque guide est choisie de telle manière qu'à partir d'une distribution d'énergie égale dans les guides au niveau du miroir M2 et à la longueur d'onde laser on récupère un maximum d'énergie dans le guide central s'étendant jusqu'au miroir M1. L'énergie se répartit par couplage mutuel entre les guides qui forment l'équivalent d'une lentille optique intégrée. Les électrodes servent là encore à modifier les phases pour optimiser le transfert progressif de l'énergie dans le guide central.

Ce dispositif permet d'augmenter la puissance disponible dans un guide laser monomode grâce à l'augmentation du nombre de sources de pompage. Ceci est particulièrement intéressant si on veut coupler la sortie du laser (au niveau du miroir M1) à une fibre optique monomode ou bien si on cherche à doubler en fréquence (génération de rayonnement vert à 0,54 $\mu$m dans le cas du matériau laser Nd : $LiN_bO_3$ émettant 1,084 $\mu$m) l'énergie laser se propageant dans le guide central.

**Revendications**

1. Structure de laser comportant une pluralité de guides optiques (12) juxtaposés couplés optiquement latéralement et réalisés dans un substrat solide (10) électrooptique et susceptible d'émettre de la lumière stimulée, caractérisé en ce qu'elle comporte des électrodes de commande (14) pour contrôler individuellement les indices de réfraction dans les différents guides ou entre les guides.

2. Structure laser selon la revendication 1, caractérisée en ce qu'il est prévu des moyens pour appliquer à ces électrodes des potentiels individuels de manière à ajuster les phases relatives des ondes dans les différents guides.

3. Structure laser selon la revendication 2, caractérisée en ce que les guides optiques font partie intégrante d'une cavité résonnante produisant un effet laser.

4. Structure laser selon la revendication 3, caractérisée en ce que des miroirs plans (M1, M2) sont placés aux extrémités de la structure pour constituer cette cavité.

5. Structure laser selon la revendication 3, caractérisé en ce que des réseaux réfléchissants distribués (16, 18) sont placés aux extrémités de la structure.

6. Structure laser selon l'une des revendications 1 à 5, caractérisé en ce que le substrat est un cristal dopé au néodyme.

7. Structure laser selon la revendication 6, caractérisé en ce que le substrat est en niobate de lithium ou en tantalate de lithium.

8. Structure laser selon l'une des revendications précédentes, caractérisée en ce qu'elle est excitée par un laser de pompe (20) placé à une extrémité de la structure ou couplé à cette structure par une optique de transfert (22, 24) à guides optiques.

9. Structure laser selon l'une des revendications précédentes, caractérisée en ce que les guides couplés sont disposés entre deux miroirs réfléchissants, certains des guides ayant une longueur inférieure à la distance entre les miroirs.

10. Structure laser selon la revendication 1, caractérisé en ce que des électrodes sont disposées au-dessus des guides.

11. Structure laser selon la revendication 1, caractérisé en ce que les électrodes sont disposées entre les guides.

**Patentansprüche**

1. Laserstruktur mit mehreren nebeneinander angeordneten optischen Wellenleitern (12), die seitlich optisch gekoppelt sind und in einem festen elektrooptischen Substrat (10) angebracht sind und angeregtes Licht aussenden können, dadurch gekennzeichnet, daß sie zum einzelnen Steuern der Brechungsindizes in den verschiedenen Wellenleitern oder zwischen den Wellenleitern Steuerelektroden (14) aufweist.

2. Laserstruktur nach Anspruch 1, dadurch gekennzeichnet, daß Mittel vorgesehen sind, um an diese Elektroden individuelle Potentiale in der Weise anzulegen, daß die relativen Phasen der Wellen in den verschiedenen Wellenleitern eingestellt werden.

3. Laserstruktur nach Anspruch 2, dadurch gekennzeichnet, daß die optischen Wellenleiter einen integralen Bestandteil eines Resonanzhohlraums bilden, der einen Laser-Effekt erzeugt.

4. Laserstruktur nach Anspruch 3, dadurch gekennzeichnet, daß an den Enden der Struktur zur Bildung dieses Hohlraums ebene Spiegel (M1, M2) angebracht sind.

5. Laserstruktur nach Anspruch 3, dadurch gekennzeichnet, daß an den Enden der Struktur verteilte reflektierende Gitter (16, 18) angebracht sind.

6. Laserstruktur nach einem der Ansprüche 1 bis 5, dadurch gekennzeichnet, daß das Substrat ein mit Neodym dotierter Kristall ist.

7. Laserstruktur nach Anspruch 6, dadurch gekennzeichnet, daß das Substrat aus Lithiumniobat oder Lithiumtantalat besteht.

8. Laserstruktur nach einem der vorhergehenden Ansprüche, dadurch gekennzeichnet, daß sie mit Hilfe eines Pumplasers (20) angeregt wird, der an einem Ende der Struktur angebracht ist oder mit dieser Struktur über eine Übertragungsoptik (22, 24) mit optischen Wellenleiten gekoppelt ist.

9. Laserstruktur nach einem der vorhergehenden Ansprüche, dadurch gekennzeichnet, daß die gekoppelten Wellenleiter zwischen zwei reflektierenden Spiegeln angeordnet sind, wobei gewisse Wellenleiter eine Länge haben, die kleiner als der Abstand zwischen den Spiegeln ist.

10. Laserstruktur nach Anspruch 1, dadurch gekennzeichnet, daß die Elektroden über den Wellenleitern angeordnet sind.

11. Laserstruktur nach Anspruch 1, dadurch gekennzeichnet, daß die Elektroden zwischen den Wellenleitern angeordnet sind.

**Claims**

1. Laser structure comprising a plurality of juxtaposed optical waveguides (12) optically coupled laterally and made of a solid electro-optical substrate (10) capable of the emission of stimulated light, characterised in that it includes control electrodes (14) for individually controlling the refractive indices in the different guides or between the guides.

2. Laser structure according to Claim 1, characterised in that provision is made for means of applying individual potentials to these electrodes so as to adjust the relative phases of the waves in the different guides.

3. Laser structure according to Claim 2, characterised in that the optical waveguides form an integral part of a resonant cavity producing a laser effect.

4. Laser structure according to Claim 3, characterised in that plane mirrors (M1, M2) are placed at the ends of the structure in order to form this cavity.

5. Laser structure according to Claim 3, characterised in that distributed reflecting lattices (16, 18) are placed at the ends of the structure.

6. Laser structure according to one of Claims 1 to 5, characterised in that the substrate is a neodymium-doped crystal.

7. Laser structure according to Claim 6, characterised in that the substrate is made of lithium niobate or lithium tantalate.

8. Laser structure according to one of the preceding claims, characterised in that it is excited by a pumping laser (20) placed at one end of the structure or coupled to this structure by an optical transfer system (22, 24) with optical guides.

9. Laser structure according to one of the preceding claims, characterised in that the coupled guides are arranged between two reflecting mirrors, some of the guides having a length less than the distance between the mirrors.

10. Laser structure according to Claim 1, characterised in that electrodes are placed above the guides.

11. Laser structure according to Claim 1, characterised in that the electrodes are placed between the guides.

FIG.1

FIG.2a

FIG.2b

# FIG.3

# FIG.5

$$= \frac{\lambda}{2} n_{eff}$$

E

FIG.4a

12

14

E

FIG.4b

12

14

10

FIG.6

FIG.7

FIG.8

26

32

30

28

30

32

M2

M1

12

EP 0 500 882 B1

38

38

14

36

Pompe

M2

M1

FIG.9

FIG.10

EP 0 500 882 B1